# EUROPÄISCHE PATENTSCHRIFT

(11) **EP 0 538 507 B1**
(45) Veröffentlichungstag und Bekanntmachung des Hinweises auf die Patenterteilung: **27.12.1996**
(21) Anmeldenummer: 91117957.0
(22) Anmeldetag: 22.10.1991
(51) Int. Cl.: H01L 27/02

(54) **Schutzschaltung für Anschlusskontakte von monolithisch integrierten Schaltungen**
Protection circuit for connection contacts of monolithic integrated circuits
Circuit de protection pour contacts de connexion de circuits intégrés monolithiques

(43) Veröffentlichungstag der Anmeldung: 28.04.1993
(73) Patentinhaber: Deutsche ITT Industries GmbH, 79108 Freiburg (DE)
(72) Erfinder: Giebel, Burkhard, Dipl.-Ing., W-7819 Denzlingen (DE); Gehrig, Wilfried Werner, Dipl.-Ing., W-7806 March (DE)

(56) Entgegenhaltungen:
- EP-A- 0 096 651
- US-A- 4 694 315
- US-A- 5 012 317
- PATENT ABSTRACTS OF JAPAN vol. 4, no. 165 (E-034)15. November 1980 & JP-A-55 113 358

## Beschreibung

Die Erfindung betrifft eine Schutzschaltung für Anschlußkontakte von monolithisch integrierten Schaltungen gegen elektrostatische Entladungen, insbesondere von Eingangs/Ausgangsstufen in CMOS-Technik, mit Widerstands- und Ableiteinrichtungen für solche Entladungen. Unter elektrostatischen Entladungen werden im folgenden die durch ESD-Impulse (ESD = Electrical Static Discharge = elektrostatische Entladung) bewirkten Impulsströme verstanden. Die Schutzwirkung soll sich aber auch auf stationäre Ströme erstrecken, die den jeweiligen Anschlußkontakten zugeführt sind und ein thyristorartiges Durchzünden der angelegten Versorgungsspannung innerhalb der Schaltung bewirken können.

Die Erfindung betrifft ferner ein Verfahren zum Schutz von monolithisch integrierten Schaltungen gegenüber ESD-Impulsen, bei denen die ESD-Ladungen im Bereich der Anschlußkontakte mittels Widerstands- und Ableiteinrichtungen in ihrer Wirkung unschädlich gemacht werden.

Der ESD-Impuls (= Entladeimpuls) kann im ungünstigen Fall zu einem Durchschlag zwischen mindestens zwei Halbleiterzonen führen und dabei einen Kurzschlußkanal bilden, der die Schaltungsfunktion unterbindet. Besonders gefährdet ist hierbei das dünne Gate-Oxid von MOS-Transistoren. Eine andere Folge des ESD-Impulses besteht häufig darin, daß über geeignete Halbleiterstrukturen ein thyristorartiges Durchschalten zwischen der positiven und negativen Versorgungsspannung erfolgt, was im Kristall ebenfalls einen Kurzschluß erzeugt, der durch lokale Überhitzung schließlich zum Funktionsausfall führen kann. Dieses thyristorartige Durchschalten (= latch-up) kann wie bereits angegeben auch durch einen stationären Überlaststrom auf den Anschlußkontakt ausgelöst werden, insbesondere bei Eingangs/Ausgangsstufen in CMOS-Technik. Die in CMOS-Technik erforderlichen Wannen, insbesondere beim komplementären Ausgangstransistorpaar, stellen eventuell auch mit anderen Schaltungsteilen über das Substrat verbundene thyristorartige Schaltungsstrukturen dar, die sich in einen Durchschaltzustand bringen lassen und sich in diesem Zustand (= latch-up-Zustand) halten, bis der Haltestrom unterschritten wird.

Zum Schutz der Anschlußkontakte vor Zerstörung durch ESD-Impulse sind üblicherweise Widerstands- und Ableiteinrichtungen vorgesehen, die die Überlastspannungen auf niedrige Werte begrenzen und somit die ESD-Impulse möglichst im Anschlußbereich unschädlich machen. Verwendung finden so z.B. Ableitdioden, die normalerweise in Sperrichtung betrieben werden und die gegebenenfalls eine Ableitwirkung sowohl in ihrer Fluß- als auch in ihrer Durchbruch-Richtung entfalten. Die Durchbruch-Schaltschwelle streut jedoch technologieabhängig stark und ist wenig geeignet, alle Funktionseinheiten, die den jeweiligen Anschlußkontakten zugeordnet sind, sicher zu schützen. Besonders gefährdet sind bei MOS-Technik die n-Kanal-Ausgangstransistoren.

Dokument US-A-4 694 315 beschreibt eine Schutzschaltung mit Thyristoren.

Es ist daher Aufgabe der Erfindung, eine Schutzschaltung und ein entsprechendes Verfahren anzugeben, das vorwiegend über die Auslegung (= Layout) an unterschiedliche technologische Parameter angepaßt werden kann und das eine sichere Schutzwirkung gegenüber ESD-Impulsen für alle Anschlußkontakte ermöglicht, wobei die integrierte Schaltung spannungsfrei oder unter Betriebsbedingungen ist.

Eine Schutzschaltung gemäß der Erfindung ist in Anspruch 1 definiert. Ein Verfahren gemäß der Erfindung ist in Anspruch 5 definiert. Weitere Auführungs formen sind in den abhängigen Ansprüchen 2-4 und 6-8 definiert.

Die Erfindung geht von dem Grundgedanken aus, daß im Bereich jedes Anschlußkontaktes mindestens ein Vierschichtelement (= Thyristor) gebildet wird, das eine definierte Schaltschwelle aufweist und einen niederohmigen Strompfad darstellt, der vom Anschlußkontakt zu einem Versorgungsanschluß führt und insbesonders den gefährdeten n-Kanal-Transistor überbrückt. Die Schutzschaltung enthält dabei Einrichtungen, die einen unerwünschten Einfluß von diesem Vierschichtelement auf andere zündfähige Vierschichtelemente, die einen niederohmigen Strompfad zwischen dem positiven und negativen Versorgungsanschluß bilden können, minimiert.

Üblicherweise wird die Ohmigkeit des Ableit-Strompfades und die Höhe der Schaltschwelle bei einer gegebenen integrierten Schaltung über ESD- und latch-up-Festigkeitstests quantitativ überprüft. Beim ESD-Test wird beispielsweise ein auf mehrere Kilovolt aufgeladener Kondensator von 100 Pikofarad über einen Widerstand von 1500 Ohm kurzzeitig auf den Anschlußkontakt entladen. Hierdurch lassen sich definiert die Wirkungen von statischen Entladungen simulieren, die Spitzenströme von mehreren Ampere erzeugen können. Beim latch-up-Festigkeitstest wird ein stationärer oder langsam ansteigender Strom über eine Stromquelle dem jeweiligen Anschlußkontakt zugeführt und gemessen, ob ein parasitärer Thyristor in der Schaltung zündet. Wird bei diesem Test ein Stromwert von 50 Milliampere erreicht, ohne daß ein parasitärer Thyristor zündet, dann gilt die Zündfestigkeit für viele Anwendungen bereits als ausreichend.

Die Erfindung und weitere Vorteile werden nun anhand der Figuren der Zeichnung näher erläutert:
Fig. 1 zeigt ein bevorzugtes Ausführungsbeispiel der Erfindung schematisch als Schnitt durch ein Halbleiterkristall mit einer Eingangs/Ausgangsstufe in CMOS-Technik im Bereich eines Anschlußkontaktes,
Fig. 2 zeigt das Ersatzschaltbild eines erfindungsgemäßen Thyristors am Anschlußkontakt,
Fig. 3 zeigt schematisch die Aufsicht auf ein Layout entsprechend Fig. 1 und
Fig. 4 zeigt schematisch ein ausführliches Ersatzschaltbild von Fig. 1 und Fig. 3.

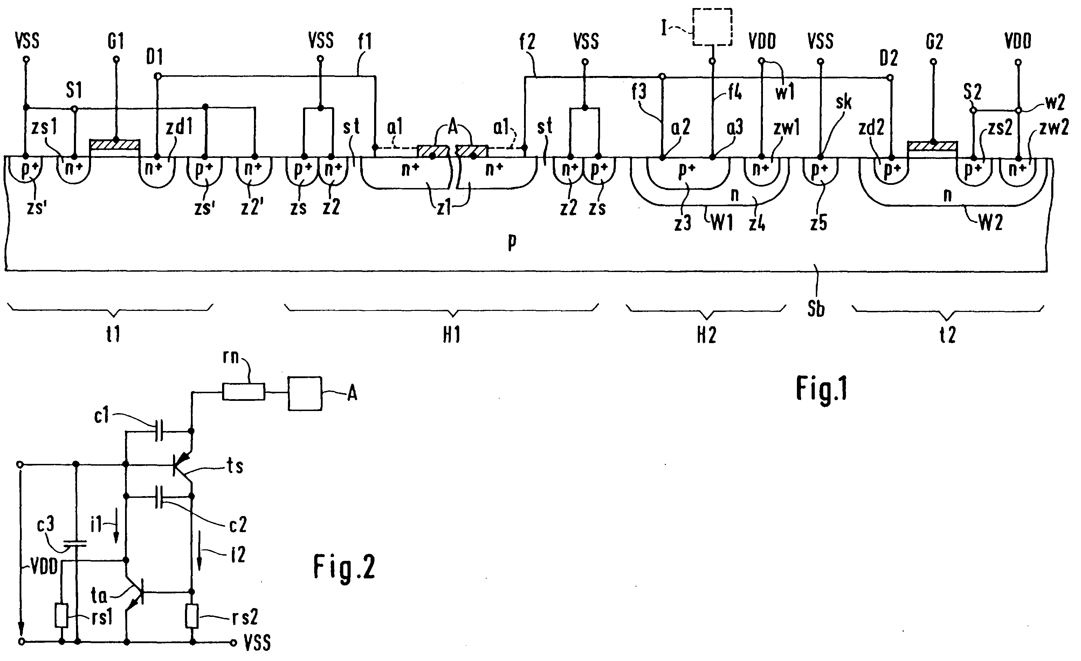

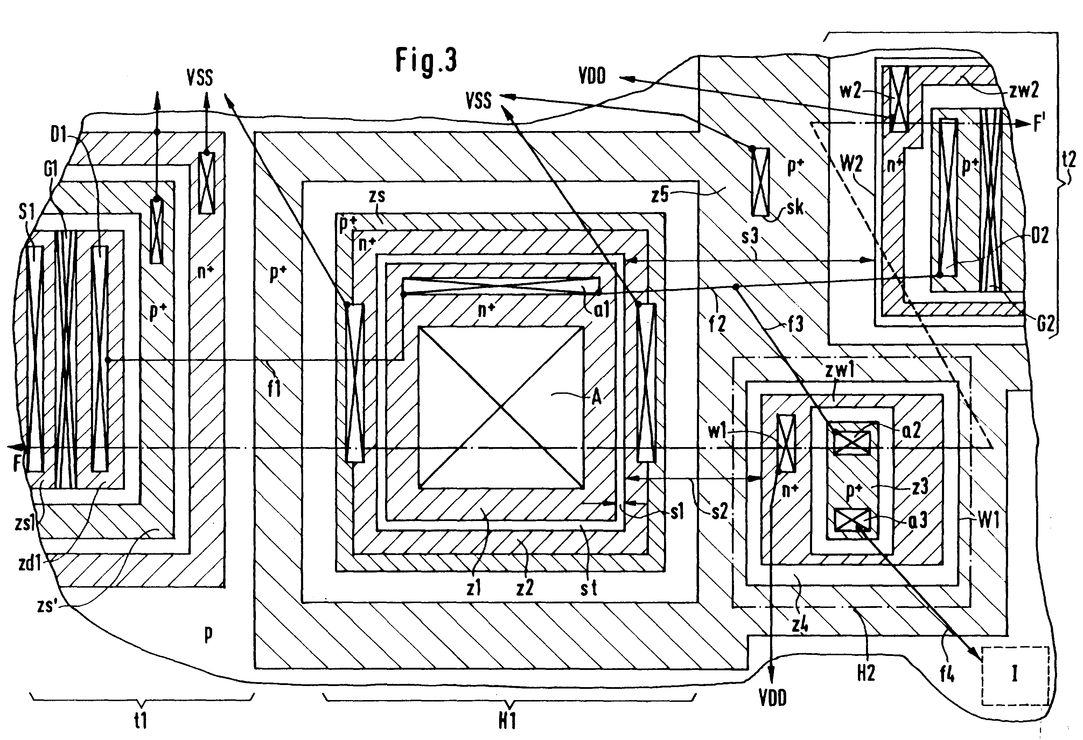

Das schematische Schnittbild von Fig. 1 durch den Halbleiterkristall entspricht etwa der Schnittlinie F, F' in Fig. 3. Die zugehörige Verdrahtung ist nur schematisch dargestellt. In das p-leitende Substrat Sb sind von der Oberfläche her verschiedene Zonen unterschiedlicher Leitungstypen eingelassen, deren jeweiliger Leitungstyp als "n" oder "p" dargestellt ist. Die Bildung der einzelnen Zonen ist möglichst an die jeweilige Technologie angepaßt, so daß die Schutzschaltung ohne zusätzliche Prozeßschritte hergestellt werden kann.

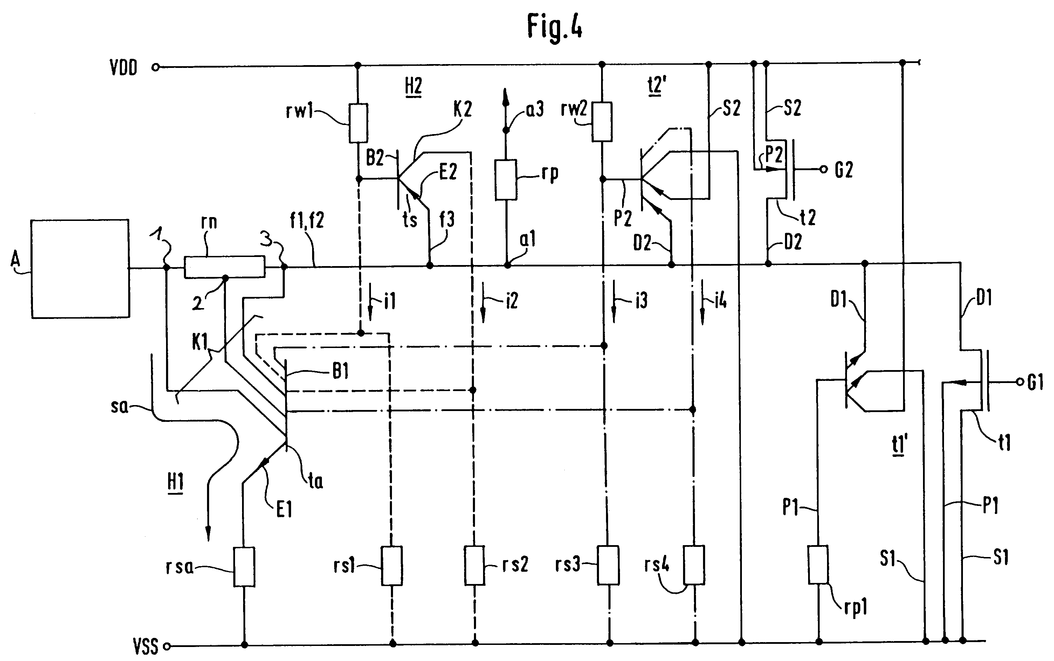

In einem ersten Halbleiterbereich H1 befindet sich der für die Bondung vorgesehene Anschlußkontakt A, der eine darunterliegende n+ leitende erste Zone z1 kontaktiert. Die erste Zone z1 ist dabei als Fläche deutlich größer als der Anschlußkontakt A und überragt diesen. Parallel zu einem Seitenrand ist auf der ersten Zone z1 ein Kontaktstreifen, nämlich der Anschluß a1, angeordnet, der über eine erste und zweite niederohmige Verbindungsleitung f1, f2 mit den Drain-Anschlüssen D1, D2 eines n- und p-Kanal-Ausgangstransistors t1, t2 verbunden ist. Die erste Zone z1 bildet dabei einen niederohmigen Widerstand rn (= erster Widerstand) (vgl. Fig. 2 und Fig. 4), dessen eines Ende direkt mit dem Anschlußkontakt A verbunden ist.

Durch einen schmalen Substratsteg st getrennt befindet sich um die erste Zone eine n+ leitende zweite Zone z2. Zweckmäßigerweise ist die zweite Zone z2 dabei mindestens teilweise ringförmig um die erste Zone z1 ausgebildet, vgl. Fig. 3. Dies schließt andere Ausführungsformen nicht aus, z.B. nur auf einer Seite angeordnet, fingerförmig, mäanderförmig oder inselförmig, wichtig ist lediglich, daß der Substratsteg st eine durch das Layout definierte Länge und Breite hat. Die zweite Zone z2 ist über Kontaktierungsanschlüsse mit der Substrat-Versorgungsspannung verbunden, die an einem ersten Versorgungsanschluß VSS liegt. Das Substrat Sb ist über eine p+ leitende Zone zs angeschlossen, die sich wie dargestellt auch unmittelbar an die zweite Zone z2 anschließen kann. Die beschriebenen Zonen z1, z2, zs definieren den ersten Halbleiterbereich H1. Mittels der ersten und der dazu lateral liegenden zweiten Zone z1, z2 wird ein Ableittransistor ta vom npn-Leitfähigkeitstyp gebildet, vgl. Fig. 2 und Fig.4. Sein verteilter Kollektor K1 (vgl. Fig. 4) wird dabei durch den Randbereich der ersten Zone z1, die Basis B1 durch den Substratsteg st und der Emitter E1 durch die zweite Zone z2 gebildet. Über die Breite des Substratsteges st und dessen Länge kann der Stromverstärkungsfaktor und die Stromergiebigkeit des Ableittransistors ta eingestellt werden.

In einem zweiten Halbleiterbereich H2, der dem ersten Halbleiterbereich H1 benachbart ist, befindet sich als wesentliche Einheit ein Dreischichtelement, nämlich ein Substrattransistor ts vom pnp-Leitfähigkeitstyp, vgl. Fig. 2 und Fig. 4. Dabei wird der Substrattransistor durch folgende Zonen gebildet: der Emitter E2 mittels einer p+ leitenden dritten Zone z3, die mit der niederohmigen zweiten Verbindungsleitung f2 verbunden ist und in einer ersten Wanne W1 liegt, die aus einer n leitenden vierten Zone z4 gebildet ist. Die erste Wanne ist mittels eines Wannenkontakts wl und einer n+ leitenden Kontaktierungszone zwl mit einem zweiten Versorgungsanschluß VDD verbunden, der an einer positiven Versorgungsspannung liegt.

Die Basis B2 des Substrattransistors ts wird aus der ersten Wanne W1 und der Kollektor K2 aus dem Substrat Sb gebildet. Die Größe des Substrattransistors und damit dessen Stromergiebigkeit wird durch die Größe der gemeinsamen Fläche von dritter und vierter Zone z3, z4 bestimmt. Die Stromverstärkung hängt von der vertikalen Struktur und dem zugehörigen Dotierungsprofil ab, das über die Implantation oder Diffusion beeinflußt werden kann und damit technologiegegeben ist. Die dritte Zone z3 ist vorteilhafterweise als p+ Widerstand rp (= zweiter Widerstand) (vgl. Fig. 4) mit den Anschlußkontakten a2, a3 ausgebildet, wobei der Anschlußkontakt a2 mittels einer dritten Verbindungsleitung f3 an die niederohmige zweite Verbindungsleitung f2 angeschlossen ist. Der vom Anschlußkontakt a2 abgewandte Anschlußkontakt a3 dient bei reinen Eingangsschaltungen und bei Eingangs/Ausgangsschaltungen in der Regel dem Anschluß der zugehörigen internen Eingangsstufen I auf dem Chip für die Signalverarbeitung. Dies hat den Vorteil, daß die Eingangsschaltungen I durch ein T-förmiges Siebglied mit den zwei Widerständen rp, rn vom Anschlußkontakt A entkoppelt sind, vgl. Fig. 4. Der p+ Widerstand rp kann dabei wesentlich hochohmiger als der n+ Widerstand rn sein.

In Fig. 1 schließt sich an das zweite Halbleitergebiet H2 ein p-Kanal-Ausgangstransistor t2 an, dessen p+ leitende Source- und Drain-Zone zs2, zd2 in einer zweiten n leitenden Wanne W2 liegen. Der Source-Anschluß S2, der Wannenanschluß w2 und die n+ leitende Kontaktierungszone zw2 sind dabei gemeinsam mit dem zweiten Versorgungsanschluß VDD verbunden. Auf der anderen Seite des ersten Halbleiterbereiches H1 befindet sich der n-Kanal-Ausgangstransistor t1, dessen n+ leitende Source- zs1 und Drain-Zone zd1 direkt im Substrat Sb liegen, wobei der Source-Anschluß S1 gemeinsam mit weiteren p+ Substratanschlüssen zs, z5 am ersten Versorgungsanschluß VSS liegt.

Die in Fig. 1 dargestellte räumliche Trennung des n- und p-Kanal-Ausgangstransistors t1, t2 ist üblich, um ein thyristorartiges Durchschalten zu verhindern. Dem gleichen Zweck dienen auch die Vielzahl der Substrat-Anschlußkontakte zs, zs', z5, welche die Substratströme nach dem ersten Versorgungsanschluß VSS ableiten sollen.

Fig. 1 zeigt ein bevorzugtes Ausführungsbeispiel mit einem Wirksamen Ableitstrompfad zwischen dem Anschlußkontakt A und dem ersten Versorgungsanschluß VSS, der durch das thyristorartige Durchschalten des ersten und zweiten Halbleiterbereiches H1, H2 gesteuert wird. Dabei soll das Durchzünden erst oberhalb einer Schaltschwelle erfolgen, die unter Betriebsbedingungen nicht erreicht wird. Andererseits soll das parasitäre Durchschalten zündfähiger anderer Strukturen, beispielsweise die n-Wanne W2, mit dem ersten Halbleiterbereich H1 verhindert werden, insbesondere wenn dadurch ein niederohmiger Kurzschlußstrompfad zwischen dem positiven und negativen Versorgungsanschluß VDD, VSS gebildet wird. Der gewünschte Ableitstrompfad sa (vgl. Fig. 4) soll lediglich zwischen dem Anschlußkontakt A und dem Substrat-Versorgungsanschluß VSS (= erster Versorgungsanschluß) gebildet werden. Selbstverständlich kann der Ableitstrompfad bei einer anderen Realisierung auch auf den zweiten Versorgungsanschluß VDD geführt werden.

Das parasitäre Durchschalten wird erfindungsgemäß wie folgt verhindert: Die parasitär zündfähigen n-Wannen, dazu gehört vor allen Dingen die Wanne W2 des p-Kanal-Ausgangstransistors t2, müssen nämlich vom ersten Halbleiterbereich H1 einen gewissen Sicherheitsabstand aufweisen, der etwa im Bereich vom fünf- bis zum fünfzigfachen der jeweiligen n-Wanneneindringtiefe liegt. Im Grunde ist jedoch der Widerstandswert des Substrat-Bahnwiderstandes entscheidend, der als flächiger Widerstand zwischen dem ersten Halbleiterbereich H1 und den zündfähigen n-Wannen liegt. In erster Näherung hängt der Bahnwiderstand vom Verhältnis von angrenzender, also benachbarter n-Wannen-Seitenlänge zum Abstand vom Substratsteg st ab, wobei die vertikale Substratstärke und die Substratdotierung als technologische Größen in die Bemessung des Bahnwiderstandes mit eingehen. Dies gilt solange die n-Wannen-Seitenlänge klein gegenüber der wirksamen Länge des Substratsteges st ist.

Durch das Auseinanderrücken wird ein Zwischenraum geschaffen, der für Einrichtungen frei ist, die die unerwünschten Substratströme i3, i4 (vgl. Fig. 4) unterbinden, indem sie mittels Auffangeinrichtungen nach dem ersten oder zweiten Versorgungsanschluß VSS bzw. VDD abgeleitet werden. Derartige Auffangeinrichtungen sind beispielsweise eine Vielzahl von Substratanschlüssen, die aus p+ leitenden fünften Zonen z5 gebildet werden und die mit dem ersten Versorgungsanschluß VSS verbunden sind. Eine andere Möglichkeit, die in Fig. 1 jedoch nicht dargestellt ist, wäre die Verwendung von Hilfskollektoren aus n+ leitenden Zonen, wobei die Hilfskollektoren die Substratströme dann nach dem zweiten Versorgungsanschluß VDD ableiten würden. Eine weitere Möglichkeit ist die Reduzierung der Stromverstärkung des Ableittransistors ta im Bereich dieser Substratströme. Der Vorteil der einzelnen Verfahren besteht darin, daß ihre Wirksamkeit quantitativ über den ESD- und latch-up-Test erfaßt werden kann und daß eine Korrektur im Layout gezielt möglich ist, ohne daß sich die einzelnen Wirkungsmechanismen gegenseitig beeinflußen. Ferner läßt sich die ESD- und die latch-up-Festigkeit in Grenzen unabhängig voneinander einstellen.

Fig. 2 zeigt schematisch den am Anschlußkontakt A liegenden Thyristor aus dem Ableittransistor ta und dem Substrattransistor ts. Die thyristorartige Verkopplung erfolgt durch den ersten und zweiten Substratstrom i1, i2. Der erste bzw. zweite Substratstrom fließt dabei von der Basis bzw. vom Kollektor des Substrattransistors ts zum Kollektor bzw. zur Basis des Ableittransistors ta. Der Abfluß der Substratströme i1 bzw. i2 in den ersten Versorgungsanschluß VSS wird durch den jeweiligen Substratwiderstand rs1 bzw. rs2 nachgebildet. Die Basis des Substrattransistors ist die erste Wanne W1 und liegt am zweiten Versorgungsanschluß VDD. Der Anschlußkontakt A liegt über den n+ Widerstand rn am Emitter des Substrattransistors ts.

Der in Fig. 2 dargestellte Thyristor kann auf zweierlei Weise gezündet werden. Entweder statisch mittels eines stationären Stroms am Anschlußkontakt A, wobei die Basis des Substrattransistors ts durch den zweiten Versorgungsanschluß VDD geklemmt wird oder zweitens dynamisch durch einen Impulsstrom am Anschlußkontakt A, wobei die Basis des Substrattransistors ts durch die hohe VDD/VSS-Gesamtkapazität (z.B. mehrere Nanofarad) dynamisch geklemmt wird. Das dynamische Zünden ist für die Schutzwirkung gegen ESD-Impulse wichtig. Infolge des Basisstroms i1 liefert der Substrattransistor ts einen Kollektorstrom i2 in die Basis des Ableittransistors ta, der über seinen Kollektorstrom den Basisstrom des Substrattransistors ts weiter erhöht. Dieser positive Rückkopplungsmechanismus setzt den Zündvorgang des Thyristors in Gang, aber nur so lange, wie am Anschlußkontakt A ein Strom ausreichender Größe zur Verfügung steht. Der eigentliche Überstrom-Ableitpfad sa, vgl. Fig. 4, ist in Fig. 2 nicht dargestellt.

Der zweite Zündvorgang des in Fig. 2 dargestellten Thyristors kann durch eine hohe Spannungsanstiegsgeschwindigkeit du/dt am Emitter des Substrattransistors ts ausgelöst werden. Dies erfolgt beispielsweise bei einem ESD-Impuls, bei dem Spannungsanstiegsgeschwindigkeiten in der Größe von 100 Volt/Nanosekunde auftreten können. Dabei erreicht der Entladeimpuls nach ca. 10 Nanosekunden sein Spannungs-Maximum in der Größenordnung von etwa 1 Kilovolt bis 10 Kilovolt. Es ist klar, daß die zugehörigen Ströme zu lokalen Zerstörungen im Halbleiterkristall führen, wenn sie nicht über leistungsfähige Mittel am Anschlußkontakt abgeleitet werden. Bei diesen schnellen Anstiegsgeschwindigkeiten reißt der Substrattransistor ts über die Reihenschaltung seiner Basis-Emitter- und Basis-Kollektor-Kapazität c1, c2 die Basis des stromlosen Ableittransistors ta mit und zieht diesen in einen schwach leitenden Zustand, der sich durch den beschriebenen positiven Rückkopplungsmechanismus weiter verstärkt, bis der Thyristor voll durchgeschaltet ist. Dieser Durchschaltmechanismus erfolgt sowohl bei angelegter Versorgungsspannung als auch beim strom- und spannungslosen Zustand - auch beim isolierten Bauelement außerhalb einer Schaltung - und bildet damit einen idealen Schutz gegen elektrostatische Entladungen über die Anschlußkontakte.

Fig. 3 zeigt in schematischer Aufsicht einen Ausschnitt des Halbleiterkristalls im Bereich des Anschlußkontaktes A. Etwa entlang der Schnittlinie FF' befinden sich die bereits im Schnitt dargestellten Halbleiterbereiche von Fig. 1. Auf der linken Seite liegt der n-Kanal-Ausgangstransistor t1 dessen Drain-Anschluß D1 über die erste Verbindungsleitung f1 mit dem Kontaktierungsanschluß a1 mit der ersten Halbleiterzone z1 verbunden ist. Die mit dem Anschlußkontakt A und Kontaktierungsanschluß a1 versehene erste Zone z1 ragt auf allen Seiten über den Anschlußkontakt A hinaus.

Mit dem vom eigentlichen Anschlußkontakt A abgewandten Kontaktierungsanschluß a1 ist auch eine zweite Verbindungsleitung f2 verbunden, die auf den Drain-Anschluß D2 des p-Kanal-Ausgangstransistors t2 führt. Dieser liegt in der zweiten n leitenden Wanne W2, die über eine n+ leitende Kontaktierungszone zw2 und einen Wannenkontakt w2 mit dem zweiten Versorgungsanschluß VDD verbunden ist.

Durch den Abstand der Kontaktierungszone a1 vom Anschlußkontakt A wird mittels der ersten Zone z1 der niederohmige n+ Widerstand rn, (vgl. Fig. 2 und Fig. 4), gebildet, der eine ohmsche Trennung des Anschlußkontaktes A von den niederohmigen Verbindungsleitungen f1, f2 bewirkt. Um diese erste Zone z1 ist ringförmig die zweite Zone z2 vom gleichen n+ Leitfähigkeitstyp gebildet, wobei der schmale Substratsteg st beide Zonen voneinander trennt. Um die zweite Zone z2 liegt ringförmig die weitere p+ leitende Zone zs, die der Kontaktierung des p-leitenden Substrats dient. Die ringförmige Zone zs und die unmittelbar anschließende zweite Zone z2 sind gemeinsam kontaktiert und mit dem ersten Versorgungsanschluß VSS verbunden. Der besseren Übersichtlichkeit wegen sind in Fig. 3 die einzelnen Zonen lediglich einmal kontaktiert. Die niederohmigen Verbindungsleitungen, die aus mehreren Verdrahtungsebenen gebildet sein können, sind vereinfacht als Linien mit Kontaktierungspunkten dargestellt.

Die zentrale Anordnung des Anschlußkontaktes A auf der ersten Zone z1 und deren ringförmige Umschließung durch die zweite Zone z2 ist natürlich nicht zwingend, jedoch ist sie sehr zweckmäßig, weil auf diese Weise zusätzlich zu dem Ableittransistor ta direkt unter dem Anschlußkontakt A mittels der ersten Zone z1 eine großflächige Ableitdiode gegenüber dem Substrat gebildet wird, die eine zusätzliche Schutzwirkung ausübt. Eine ähnliche Funktion haben die n+ leitenden Zonen z2' von Fig. 1 und Fig. 3, die mit dem ersten Versorgungsanschluß VSS verbunden sind.

Im zweiten Halbleiterbereich H2 sind diejenigen Zonen in die Oberfläche des Halbleiterkristalls eingelassen, die den Substrattransistor ts bilden, der als vertikaler pnp-Transistor ausgebildet ist. Der Basis entspricht dabei die aus der n leitenden vierten Zone z4 gebildete erste Wanne W1, die in das Substrat eingesetzt ist. Die Kontaktierung der ersten Wanne W1 erfolgt durch die niederohmige n+ leitende Kontaktierungszone zw1, die über den ersten Wannenkontakt w1 mit dem zweiten Versorgungsanschluß VDD verbunden ist. In der Wanne liegt durch einen pn-Übergang getrennt die p+ leitende dritte Zone z3, die über den Kontakt a2 und die dritte Verbindungsleitung f3 an die zweite Verbindungsleitung f2 angeschlossen ist. In Fig. 3 ist die dritte Zone z3 rechteckförmig als Widerstandselement dargestellt, dessen zweiter Anschluß durch den Kontakt a3 gebildet ist. Über diesen p+ Widerstand rp, (vgl. Fig. 2 und Fig. 4), und eine vierte Verbindungsleitung f4 werden die in Fig. 3 nur schematisch dargestellten Eingangsschaltungen I an den Anschlußkontakt A angeschlossen. Bei einer reinen Ausgangsstufe entfällt die vierte Verbindungsleitung f4 und der zugehörige Anschlußkontakt a3.

In Fig. 3 ist die mit dem ersten Halbleiterbereich H1 zündfähige zweite Wanne W2 um den Abstand s3 vom Substratsteg st abgerückt. In den Zwischenbereich ist eine breite Zone, die p+ leitende fünfte Zone z5, eingelassen, die über eine nicht dargestellte Vielzahl von Substratkontakten sk mit dem ersten Versorgungsanschluß VSS verbunden ist. Zwischen dem ersten und zweiten Halbleiterbereich H1, H2 befindet sich ebenfalls eine p+ leitende Substrat-Kontaktierung aus der fünften Zone z5, die jedoch deutlich schmäler ist als im Bereich der zweiten Wanne W2. Durch den Abstand s2 zwischen dem ersten und zweiten Halbleiterbereich, die dazwischenliegende Substrat-Kontaktierung und durch die Breite s1 des Substratsteges st kann das Zündverhalten des gewünschten Thyristors über das Layout definiert beeinflußt werden.

Fig. 4 zeigt schließlich ein ausführliches Ersatzschaltbild der Darstellungen nach Fig. 1 und Fig. 3. Die an den Anschlußkontakt A angeschlossene erste Zone z1 bildet den n+ leitenden Widerstand rn, an dem die erste und zweite Verbindungsleitung f1, f2 angeschlossen sind. Zudem bildet die erste Zone z1 in Verbindung mit der zweiten Zone z2 und dem Substratsteg st einen lateralen npn-Transistor, nämlich den Ableittransistor ta. Dieser weist in der ersten Zone z1 entlang des Substratsteges st einen verteilten Kollektor K1 auf, der in Fig. 4 als Mehrfachkollektor dargestellt ist. Drei dieser Kollektoren sind an die drei Abgriffpunkte 1, 2, 3 des Widerstandes rn angeschlossen.

Dem Abgriff 1 entspricht in Fig. 3 diejenige Randzone von z1, die nicht mehr im Einflußbereich der Kontaktierungszone al liegt. Dem Abgriff 3 entspricht diejenige Randzone von z1, die etwa längs der Kontaktierungszone a1 liegt. Dem Abgriff 2 entsprechen schließlich die etwa zwischen diesen beiden Randbereichen liegenden Zwischenzonen. Aus Fig. 3 ist entnehmbar, daß etwa 2/3 des Randbereiches der ersten Zone z1 als Hauptkollektor dem Angriff 1 zuzurechnen sind. Dieser bildet den niederohmigen Ableitstrompfad sa für die ESD-Impulse oder Überlastströme, die auf den Anschlußkontakt A gelangen. Der Widerstand für diesen Strompfad sa ergibt sich im wesentlichen aus seinem Substratwiderstand rsa, der in den Emitter-Strompfad des Ableittransistors ta eingezeichnet ist. Der Emitter E1 wird durch die zweite Zone z2 gebildet.

Ein Teil des vom Emitter E1 injizierten Stroms gelangt nicht in die zweite Zone z2 sondern in das Substrat Sb. Dies wird im verteilten Kollektor K1 durch die gestrichelt dargestellten Kollektoren symbolisiert. Dabei gelangt ein Teil des Substratstromes als erster Substratstrom il in den ersten Halbleiterbereich H1. Ein unerwünschter Teil des Substratstromes gelangt als dritter Substratstrom i3 in den Bereich des p-Kanal-Ausgangstransistors t2.

Der zweite Halbleiterbereich H2 bildet einen vertikalen pnp-Transistor, nämlich den Substrattransistor ts. Dessen Emitter E2 ist über den n+ Widerstand rn mit dem Anschlußkontakt A verbunden. Die Basis B2 liegt über einen von der ersten Wanne W1 gebildeten Wannenwiderstand rwl am zweiten Versorgungsanschluß VDD. Der Kollektor K2 ist durch das Substrat Sb gebildet und liefert den zweiten Substratstrom i2, der teilweise auf die Basis B1 des Ableittransistors ta gelangt. Da ein Teil des ersten Substratstromes i1 an die Basis B2 des Substrattransistors ts gelangt, können diese beiden Transistoren thyristorartig zusammenwirken. Dies ist aber nur möglich, so lange das Potential am Anschlußkontakt A um eine Basis-Emitter-Schwellspannung größer ist als das Potential an der Basis B2. Die beiden Transistoren können keinen Kurzschluß zwischen den beiden Versorgungsanschlüsse VDD, VSS bewirken. Die Ersatzwiderstände rs1 bzw. rs2 entsprechen den Substratkontaktierungen zs zwischen der ersten und zweiten Halbleiterzone H1, H2, die den ersten bzw. zweiten Substratstrom i1, i2 definiert reduzieren.

Der verteilte Kollektor K1 speist den unerwünschten Substratstrom i3 in die Basis eines parasitären pnp-Substrattransistors t2', der sich zwangsweise aus dem p-Kanal-Ausgangstransistor t2 ergibt. Besonders gefährlich ist, daß bei diesem parasitären Transistor t2' einer der Doppelemitter direkt mit dem zweiten Versorgungsanschluß VDD verbunden ist. Bei der Aktivierung dieses Transistors t2' hätte dieser Emitteranschluß einen sehr großen Substratstrom i4 zur Basis B1 zur Folge, der mittels des dritten Substratstroms i3 den Mitkopplungs-Stromkreis eines zündfähigen parasitären Thyristors ta, t2' bilden würde. Dieser würde sich unabhängig vom Potential am Anschlußkontakt A selber halten (= latch-up-Zustand), solange der Thyristorstrom aus dem niederohmigen zweiten Versorgungsanschluß VDD gespeist wird. Die unerwünschten Substratströme i3, i4 werden indessen durch entsprechende Auffangeinrichtungen z5 möglichst klein gehalten, im einfachsten Fall durch eine großflächige Substratkontaktierung zwischen der ersten Halbleiterzone H1 und der zündfähigen Wanne W2, vgl. Fig. 3. Die möglichst vollständige Ableitung der unerwünschten Substratströme i3 bzw. i4 wird in Fig. 4 durch die Substratwiderstände rs3 bzw. rs4 symbolisiert.

Dem n-Kanal-Ausgangstransistor t1 ist als parasitäres Element bekanntlich ein parasitärer npn-Substrattransistor t1' mit Doppelemitter parallel geschaltet. Der eine Emitter, der dem Drain-Anschluß D1 zugehört, liegt an der ersten Verbindungsleitung f1 und der andere Emitter, der dem Source-Anschluß S1 zugehört, ist fest mit dem ersten Versorgungsanschluß VSS verbunden. Mit dem Ableittransistor ta kann der parasitäre Transistor tl' nicht thyristorartig zusammenwirken, wohl aber mit dem parasitären pnp-Substrattransistor t2'. Dieser unerwünschte Effekt wird wie bereits beschrieben durch übliche Maßnahmen verhindert, beispielsweise durch die in Fig. 3 dargestellte räumliche Trennung auf gegenüberliegenden Seiten des Anschlußkontaktes A.

Der Bulk-Anschluß P1, P2 des n- bzw. p-Kanal-Ausgangstransistors t1, t2 bildet den Basisanschluß des parasitären npn- bzw. pnp-Substrattransistors t1', t2' mit dem zugehörigen Bulk-Ersatzwiderstand rp1 bzw. rw2 nach dem ersten bzw. zweiten Versorgungsanschluß VSS bzw. VDD.

Die Ausführungsbeispiele beziehen sich auf monolithisch integrierte CMOS-Schaltungen mit p-Substrat. Selbstverständlich kann die Erfindung auch für Schutzschaltungen von CMOS-Schaltungen verwendet werden, die von einem n-Substrat ausgehen. Die Erfindung ist ferner auf alle Technologien anwendbar, mit denen sich Vierschichtelemente darstellen lassen. Die Schutzschaltung nach der Erfindung kann auch für Bipolarschaltungen verwendet werden, da die Schutzmechanismen auf rein bipolaren Schaltungsfunktion beruhen, die mit oder ohne Verwendung von MOS-Transistoren mittels üblicher Herstellungsverfahren von monolithisch integrierten Schaltungen - insbesondere über Layoutmaßnahmen - realisierbar sind.

## Patentansprüche

1. Schutzschaltung für Anschlußkontakte von monolithisch integrierten Schaltungen gegen elektrostatische Entladungen, insbesondere von Eingangs/Ausgangsstufen in CMOS-Technik, mit Widerstands- und Ableiteinrichtungen für solche Entladungen, mit folgenden Merkmalen:
- im Bereich jedes Anschlußkontaktes (A) befindet sich mindestens ein Vierschichtelement (ta, ts) mit einer definierten Schaltschwelle und einem niederohmigen Ableitstrompfad (sa) vom Anschlußkontakt (A) zu einem Versorgungsanschluß (VSS, VDD),
- die Schutzschaltung enthält Einrichtungen (z5), die einen Stromfluß (i3, i4) im Substrat (Sb) zwischen mindestens Teilen des Vierschichtelementes (ta, ts) und anderen Elementen (t2'), mit denen Teile (ta) des Vierschichtelementes andere Vierschichtelemente (ta, t2') bilden, unterbinden, wobei
- das Vierschichtelement (ta, ts), das in einem ersten und einem zweiten Halbleiterbereich (H1, H2) mittels Zonen gebildet ist, die in die Oberfläche des Halbleiterkristalls eingelassen sind, im ersten Halbleiterbereich (H1) in lateraler Anordnung durch einen Substratsteg (st) getrennt eine erste und eine mit dem ersten Versorgungsanschluß (VSS) verbundene zweite Zone (z1, z2) eines zweiten Leitfähigkeitstyps, enthält und
- das Vierschichtelement (ta, ts) ferner mindestens ein Dreischichtelement (ts) enthält, das aus dem Substrat (Sb), einer als Wanne (W1) in das Substrat eingelassenen Halbleiterzone (z4) und einer in die Wanne eingelassenen dritten Halbleiterzone (z3) besteht, wobei die Leitfähigkeitstypen der aufeinanderfolgenden Schichten (Sb, z4, z3) des Dreischichtelementes, welches einen Substrat transistor bildet, jeweils invertiert sind und das Substrat (Sb) einem ersten Leitfähigkeitstyp entspricht,
gekennzeichnet durch folgende Merkmale:
- die erste Zone (z1) erstreckt sich flächig als leitende Verbindung mindestens zwischen dem Anschlußkontakt (A) und einer vom Anschlußkontakt lateral getrennten, Kontaktierungszone (a1) die mit einer ersten und zweiten Verbindungsleitung (f1, f2) verbunden ist an die insbesondere die Drain-Anschlüsse (D1, D2) von komplementären CMOS-Ausgangstransistoren (t1, t2) angeschlossen sind, wobei durch den Abstand der Kontaktierungs zone (a1) vom Anschlußkontakt A mittels der ersten Zone (z1) ein niederohmigen Widerstand (rn) gebildet wird,
- der zweite Halbleiterbereich (H2) enthält die dritte Zone (z3) vom ersten Leitfähigkeitstyp, die mittels einer dritten Verbindungsleitung (f3) über die zweite Verbindung leitung (f2) mit der Kontaktierungszone (a1) verbunden ist, und
- der laterale Abstand (s1) zwischen der ersten und zweiten Zone (z1, z2) und der Abstand (s2) zwischen dem ersten und zweiten Halbleiterbereich (H1, H2) und die Längen der jeweils benachbarten Randzonen sind jeweils so bemessen, daß der niederohmige Ableitstrompfad (sa), der durch das thyristorartige Zusammenwirken des ersten und zweiten Halbleiterbereichs gesteuert ist, nach Erreichen der Zündschwelle mindestens einen vorgegebenen Leitfähigkeitswert aufweist und daß andererseits die Zündschwelle bei normalen Betriebsbedingungen nicht erreicht wird.

2. Schutzschaltung nach Anspruch 1, dadurch gekennzeichnet, daß der Abstand (s2) zwischen dem ersten und zweiten Halbleiterbereich (H1, H2) kleiner ist als der Abstand (s3) zwischen dem ersten Halbleiterbereich (H1) und weiteren zündfähigen Wannen (W2) vom zweiten Leitfähigkeitstyp und daß der Zwischenbereich zwischen dem ersten Halbleiterbereich (H1) und den weiteren Wannen (W2) eine Vielzahl von Auffangeinrichtungen (z5) für unerwünschte Substratströme (i3, i4) enthält, wobei die Auffangeinrichtungen mit dem ersten oder zweiten Versorgungsanschluß (VSS, VDD) verbunden sind.

3. Schutzschaltung nach Anspruch 2, dadurch gekennzeichnet, daß die zweite Zone (z2) mindestens teilweise die erste Zone (z1) ringförmig umgibt und daß die erste Zone (z1) mindestens teilweise über den vom Anschlußkontakt (A) überdeckten Bereich hinausragt.

4. Schutzschaltung nach Anspruch 3, dadurch gekennzeichnet, daß an einen vom Anschlußkontakt (A) abgewandten Anschluß (a3) der dritten Zone (z3) diejenigen Schaltungsteile über eine vierte Verbindungsleitung (f4) angeschlossen sind, bei denen der Anschlußkontakt (A) als Signaleingang dient.

5. Verfahren zum Schutz von monolithisch integrierten Schaltungen gegenüber ESD-Impulsen, bei denen die ESD-Ladungen im Bereich der Anschlußkontakte mittels Widerstands- und Ableiteinrichtungen in ihrer Wirkung unschädlich gemacht werden, dabei steht ESD für Electrical Static Discharge = elektrostatische Entladung, wobei das Verfahren folgende Verfahrensmerkmale aufweist:
- die ESD-Impulse werden vom Anschlußkontakt (A) mittels eines von einem Vierschichtelement (ta, ts) gesteuerten niederohmigen Ableitstrompfads (sa) zu einem Versorgungsanschluß (VSS, VDD) abgeleitet, dabei weist das Vierschichtelement eine definierte Schaltschwelle auf,
- unerwünschte Substratströme (i3, i4) zwischen dem Vierschichtelement (ta1, ts) und weiteren zündfähigen Wannen (W2) werden durch eine Vielzahl von Auffangeinrichtungen (z5) unterbunden, indem die Auffangeinrichtungen die Ströme nach dem ersten und/oder dem zweiten Versorgungsanschluß (VSS, VDD) ableiten,
- im ersten Halbleiterbereich (H1) wird mittels der ersten und einer dazu lateral liegenden zweiten Zone (z1, z2) gleichen Leitfähigkeitstyps ein Ableittransistor (ta) gebildet, dessen Kollektor (K1) der Randbereich der ersten Zone (z1), dessen Basis (Bl) das Substrat (Sb) und dessen Emitter (E1) die mit dem ersten Versorgungsanschluß (VSS) verbundene zweite Zone (z2) ist, wobei die erste und zweite Zone durch einen Substratsteg (st) getrennt sind, und
- in einem zum ersten Halbleiterbereich (H1) benachbarten zweiten Halbleiterbereich (H2) wird ein Substrattransistror (ts) gebildet, dessen Leitungstyp invers zum Ableittransistor (ta) ist, wobei der Substrattransistor durch folgende Zonen gebildet wird:
-- der Emitter (E2) mittels einer dritten Zone (z3), die mittels einer dritten Verbindungsleitung (f3) an eine niederohmige zweite Verbindungsleitung (f2) angeschlossen und in eine erste Wanne (W1) eingelassen ist, wobei die erste Wanne mit dem zweiten Versorgungsanschluß (VDD) verbunden wird,
-- die Basis (B2) mittels der ersten Wanne (W1) und
-- der Kollektor (K2) mittels des Substrats (Sb),
- der Anschlußkontakt (A) wird in einem ersten Halbleiterbereich (H1) mittels der ersten Zone (z1), welche sich flächig als leitende Verbindung mindestens zwischen dem Anschlußkontakt (A) und einer, vom Anschlußkontakt lateral getrennten, Kontaktierungszone (a1) erstreckt und durch den Abstand der Kontaktierungszone vom Anschlußkontakt einen ersten niederohmigen Widerstand (rn) bildet, mit der Kontaktierungszone, welche mit einer niederohmigen ersten und der zweiten Verbindungsleitung (f1, f2) kontaktiert ist, verbunden, und
- mittels des Abstandes (s1) zwischen der ersten und zweiten Zone (z1, z2) und mittels des Abstandes (s2) zwischen dem ersten und zweiten Halbleiterbereich (H1, H2), deren jeweiliger flächiger Ausdehnung sowie der Länge der jeweils benachbarten Randzonen wird die Schaltschwelle für das thyristorartige Durchschalten des Ableittransistors (ta) und des Substrattransistors (ts) und die Leitfähigkeit des Ableitstrompfades (sa) eingestellt.

6. Verfahren nach Anspruch 5, gekennzeichnet durch folgende Merkmale:
- das thyristorartige Durchschalten des Ableittransistors (ta) mit weiteren zündfähigen Wannen (W2) wird durch die Größe des Abstandes (s3) zu diesen weiteren Wannen und durch Ableitung der unerwünschten Substratströme (i3, i4) mittels Auffangeinrichtungen (z5) in dem durch den Abstand (s3) definierten Zwischenbereich unterbunden.

7. Verfahren nach Anspruch 6, dadurch gekennzeichnet, daß die Ableitung der unerwünschten Substratströme (i3, i4) mittels einer Vielzahl von Substratanschlüssen erfolgt, die aus einer fünften Zone (z5) vom gleichen Leitfähigkeitstyp wie das Substrat (Sb) gebildet und mit dem ersten Versorgungsanschluß (VSS) verbunden sind und flächig zwischen dem Ableittransistor (ta) und den weiteren zündfähigen Wannen (W2) liegen.

8. Verfahren nach Anspruch 7, dadurch gekennzeichnet, daß mittels der dritten Zone (z3) ein zweiter Widerstand (rp) gebildet wird, an dessen abgewandtem Anschlußkontakt (a3) eine vierte Verbindungsleitung (f4) für zugehörige Eingangsstufen (I) angeschlossen ist.

## Claims

1. A protective circuit for protecting connecting contacts of monolithic integrated circuits, particularly of input/output stages implemented in CMOS technology, from electrostatic discharges, comprising resistive and sink devices for such discharges, with the following features:
- In the area of each connecting contact (A) there is at least one four-layer device (ta, ts) with a defined switching threshold and a low-resistivity sink path (sa) from the connecting contact (A) to a supply terminal (VSS, VDD);
- the protective circuit comprises devices (z5) which prevent a flow of current (i3, i4) in the substrate (Sb) between at least parts of the four-layer device (ta, ts) and other elements (t2') with which parts (ta) of the four-layer device form other four-layer devices (ta, t2'), wherein
- the four-layer device (ta, ts), which is formed in a first semiconductor zone (M1) and a second semiconductor zone (H2) by means of regions formed into the surface of the chip, contains in the first semiconductor zone (H1), in a lateral configuration, a first region (z1) and a second region (z2) of a second conductivity type which are separated by a substrate wall (st), said second region (z2) being connected to the first supply terminal, and
- the four-layer device (ta, ts) contains at least one three-layer device (ts) consisting of the substrate (Sb), a semiconductor region (z4) formed in the substrate as a tub (W1), and a third semiconductor region (z3) disposed in the tub, with the conductivity types of the successive layers (Sb, z4, z3) of the three-layer device being opposite to each other and the substrate (Sb) being of a first conductivity type, said three-layer device forming a substrate transistor,
characterized by the following features:
- The first region (z1) provides a conductive connection between at least the connecting contact (A) and a contact pad (al) which is laterally separated from the connecting contact and which is connected to a first and a second interconnection (f1, f2) to which the drain terminals (D1, D2) of complementary CMOS output transistors (tl, t2) are preferably connected, a low-value resistor (rn) being formed through the distance of the contact pad (al) from the connecting contact (A) by means of the first region (z1);
- the second semiconductor zone (H2) contains the third region (z3) of the first conductivity type, which is connected to the contact area (al) by a third interconnection (f2); and
- the lateral distance (s1) between the first and second regions (z1, z2), the distance (s2) between the first and second semiconductor zones (H1, H2), and the lengths of the respective adjacent edge regions are so chosen that after attainment of the breakdown threshold, the low-resistivity sink path (sa), which is controlled by the thyristor-like interaction of the first and second semiconductor zones, has at least a predetermined conductivity value, and that, on the other hand, the breakdown threshold is not reached under normal operating conditions.

2. A protective circuit as claimed in claim 1,
characterized in that the distance (s2) between the first and second semiconductor zones (H1, H2) is less than the distance (s3) between the first semiconductor zone (H1) and further triggerable tubs (W2) of the second conductivity type, and that the intermediate region between the first semiconductor zone (H1) and the further tubs (W2) contains a plurality of collecting devices (z5) for unwanted substrate currents (i3, i4), said collecting devices being connected to the first or second supply terminal (VSS, VDD).

3. A protective circuit as claimed in claim 2,
characterized in that the second region (z2) surrounds at least part of the first region (z1) in the form of a ring, and that the first region (zl) extends, at least in part, beyond the region covered by the connecting contact (A).

4. A protective circuit as claimed in claim 3,
characterized in that those subcircuits for which the connecting contact (A) serves as a signal input are connected by a fourth interconnection (f4) to a contact (a3) of the third region (z3) which is remote from the connecting contact (A).

5. A method of protecting monolithic integrated circuits from ESD pulses (ESD = electrostatic discharge) wherein the electrostatic charges in the area of the connecting contacts are neutralized by means of resistive and sink devices, said method having the following features:
- For the ESD pulses, a low-resistivity sink path (sa) controlled by means of a four-layer device (ta, ts) is provided from the connecting contact (A) to a supply terminal (VSS, VDD), said four-layer device having a defined switching threshold; and
- unwanted substrate currents (i3, i4) between the four-layer device (ta, ts) and further triggerable tubs (W2) are prevented by a plurality of collecting devices (z5) draining the currents to the first supply terminal (VSS) and/or the second supply terminal (VDD);
- in a first semiconductor zone (H1), a first region (z1) and a lateral second region (z2) of the same conductivity type form a sink transistor (ta) whose collector (K1), base (B1), and emitter (El) are, respectively, the edge portion of the first region (z1), the substrate (Sb), and the second region (z2), which is connected to the first supply terminal (Vss), with the first and second regions separated by a substrate wall (st); and
- in a second semiconductor zone (H2) adjacent to the first semiconductor zone (H1) a substrate transistor (ts) is formed whose conductivity type is opposite to that of the sink transistor (ta), the substrate transistor being formed by the following regions:
-- the emitter (E2) by means of a third region (z3) which is connected to a low-resistance second interconnection (f2) by a third interconnection (f3) and is disposed in a first tub (W1) connected to the second supply terminal (VDD),
-- the base (B2) by means of the first tub (W1), and
-- the collector (K2) by means of the substrate (Sb);
- the connecting contact (A) is connected by means of the first region (z1), which extends as a conductive connection between at least the connecting contact (A) and a contact pad (al) laterally separated from the connecting contact and which forms a first low-value resistor (rn) through the distance of the contact pad from the connecting contact, to said contact pad, which is connected to a low-resistance first interconnection (f1) and a low-resistance second interconnection (f2); and
- by means of the distance (s1) between the first and second regions (z1, z2) and by means of the distance (s2) between the first and second semiconductor zones (H1, H2), their respective superficial areas, and the lengths of the respective adjacent edge regions, the switching threshold for the latch-up of the sink transistor (ta) and the substrate transistor (ts) as well as the conductivity of the sink current path (sa) are set.

6. A method as claimed in claim 5, characterized by the following features:
- Latchup of the sink transistor (ta) with further triggerable tubs (W2) is prevented by the magnitude of the distance (s3) to said further tubs and by draining the unwanted substrate currents (i3, i4) away by means of collecting devices (z5) in the intermediate zone defined by said distance (s3).

7. A method as claimed in claim 10, characterized in that the unwanted substrate currents (i3, i4) are drained away via a plurality of substrate connections which are formed by a fifth region (z5) of the same conductivity type as the substrate (Sb), are connected to the first supply terminal (VSS), and are located as contact areas between the sink transistor (ta) and the further triggerable tubs (W2).

8. A method as claimed in claim 2, characterized in that by means of the third region (z3), a second resistor (rp) is formed which has a fourth interconnection (f4) for associated input stages (I) connected to its contact (a3) remote from the connecting contact (A).

## Revendications

1. Circuit de protection pour contacts de connexion de circuits intégrés monolithiques vis-à-vis de décharges électrostatiques, notamment d'étages d'entrée/ sortie dans la technique CMOS, comportant des dispositifs à résistances et des dispositifs de dérivation pour de telles décharges, présentant les caractéristiques suivantes :
- dans la zone de chaque contact de connexion (A) est situé au moins un élément (ta, ts) à quatre couches possédant un seuil de commutation défini et une voie de courant de dérivation (sa) de faible valeur ohmique partant du contact de connexion (A) pour atteindre une borne d'alimentation (VSS, VDD),
- le circuit de protection contient des dispositifs (z5), qui bloquent un flux de courant (i3, i4) dans le substrat (Sb) entre au moins des parties de l'élément (ta, ts) à quatre couches et d'autres éléments (t2'), avec lesquels des parties (ta) de l'élément à quatre couches forment d'autres éléments (ta, t2') à quatre couches,
et dans lequel
- l'élément (ta, ts) à quatre couches, qui est formé dans des première et seconde régions semiconductrices (H1, H2) par des zones, qui sont ménagées dans la surface du cristal semiconducteur, et qui contient selon une disposition latérale, dans une première région semiconductrice (H1), une première zone (z1) possédant un second type de conductivité et une seconde zone (z2) possédant ce second type de conductivité et reliée à la borne d'alimentation (VSS), ces zones étant séparées par une barrette (st) du substrat, et
- l'élément (ta, ts) à quatre couches contient en outre au moins un élément (ts) à trois couches, qui est constitué par le substrat (Sb), par une zone semiconductrice (z4) ménagée dans le substrat sous la forme d'une cuvette (W) et une troisième zone semiconductrice (z3) ménagée dans la cuvette, les types de conductivité des couches successives (Sb, z4, z3) de l'élément à trois couches, qui forme un transistor de substrat, étant respectivement inversées, tandis que le substrat (Sb) correspond à un premier type de conductivité,
caractérisé par les caractéristiques suivantes
- la première zone (z1) s'étend à plat sous la forme d'une liaison conductrice au moins entre le contact de connexion (A) et, une zone de contact (al) séparée latéralement du contact de connexion et qui est reliée à des première et seconde lignes de liaison (fl, f2), auxquelles sont raccordées notamment les bornes (D1, D2) de transistors MOS complémentaires de sortie (tl, t2), une résistance de faible valeur ohmique (rn) étant formée par la distance entre la zone de contact (al) et le contact de connexion (A) au moyen de la première zone (z1),
- la seconde région semiconductrice (H2) contient la troisième zone (z3) possédant le premier type de conductivité, qui est reliée au moyen d'une troisième ligne de liaison (f3) à la zone de contact (al) par l'intermédiaire de la seconde ligne de liaison (f2), et
- la distance latérale (s1) entre les première et seconde zones (z1, z2) et la distance (s2) entre les première et seconde régions semiconductrices (H1, H2) et les longueurs des zones marginales respectivement voisines sont respectivement dimensionnées de telle sorte que la voie de courant de dérivation de faible valeur ohmique (sa), qui est commandée par la coopération, à la manière d'un thyristor, des première et seconde régions semiconductrices, possède au moins une valeur de conductivité prédéterminée une fois atteint le seuil d'amorçage et que d'autre part le seuil d'amorçage n'est pas atteint dans des conditions normales de fonctionnement.

2. Circuit de protection suivant la revendication 1, caractérisé en ce que la distance (s2) entre les première et seconde régions semiconductrices (H1, H2) est inférieure à la distance (s3) entre la première région semiconductrice (H1) et d'autres cuvettes aptes à s'amorcer (W2) possédant le second type de conductivité et que la zone intermédiaire entre la première région semiconductrice (H1) et les autres cuvettes (W2) contient une multiplicité de dispositifs de réception (z5) pour des courants indésirables de substrat (i3, i4), les dispositifs de collecte étant reliés à la première ou à la seconde borne d'alimentation (VSS, VDD).

3. Circuit de protection suivant la revendication 2, caractérisé en ce que la seconde zone (z2) entoure au moins partiellement sous une forme annulaire la première zone (z1) et que la première zone (z1) s'étend au moins partiellement au-delà de la région recouverte par le contact de connexion (A).

4. Circuit de protection suivant la revendication 3, caractérisé en ce que les éléments du circuit, pour lesquels le contact de connexion (A) est utilisé comme entrée de signal, sont raccordés par l'intermédiaire d'une quatrième ligne de liaison (f4) à une borne (a3), tournée à l'opposé du contact de connexion (A), de la troisième zone (z3).

5. Procédé pour protéger des circuits intégrés monolithiques vis-à-vis d'impulsions ESD, dans lesquelles l'effet des charges ESD est rendu non dangereux dans la zone des contacts de connexion, à l'aide des dispositifs de résistance et des dispositifs de dérivation, ESD désignant Electrical Static Discharge = décharge électrostatique, le procédé présentant les caractéristiques opératoires suivantes :
- les impulsions ESD sont dérivées du contact de connexion (A) au moyen d'un trajet de courant de dérivation (sa) de faible valeur ohmique, commandé par un élément (ta, ts) à quatre couches, en direction d'une borne d'alimentation (VSS, VDD), l'élément à quatre couches possédant un seuil de commutation défini,
- des courants indésirables de substrat (i3, i4) entre l'élément (a1, ts) à quatre couches et d'autres cuvettes aptes à s'amorcer (W2) sont interrompus par une multiplicité de dispositifs de collecte (z5), par le fait que les dispositifs de collecte dérivent les courants en direction de la première et/ou de la seconde borne d'alimentation (VSS, VDD),
- dans la première région semiconductrice (H1) est formé, au moyen d'une première zone (z1) et d'une seconde zone (z2), disposée latéralement par rapport à la précédente, ces deux zones possédant le même type de conductivité, un transistor de dérivation (ta), dont le collecteur (K1) est la partie marginale de la première zone (z1), dont la base (V1) est le substrat (Sb) et dont l'émetteur est la seconde zone (z2) reliée à la première borne d'alimentation (VSS), les première et seconde zones étant séparées par une barrette (St) du substrat, et
- dans une seconde région semiconductrice (H2), qui est voisine de la première région semiconductrice (H1), est formé un transistor de substrat (ts), dont le type de conductivité est inverse de celui du transistor de dérivation (ta), le transistor de substrat étant formé par les zones suivantes :
-- l'émetteur (E2) formé au moyen d'une troisième zone (z3) qui est connectée au moyen d'une troisième ligne de liaison (f3) à une seconde ligne de liaison (f2) de faible valeur ohmique et est ménagée dans une première cuvette (W1), la première cuvette étant reliée à la seconde borne d'alimentation (VDD),
-- la base (B2) formée au moyen de la première cuvette (W1) , et
-- le collecteur (K2) formé au moyen du substrat (Sb),
- le contact de connexion (A) est formé dans une première région semiconductrice (H1) au moyen de la première zone (z1), qui s'étend sur une certaine étendue sous la forme d'une liaison conductrice au moins entre le contact de connexion (A) et une zone de contact (a1), séparée latéralement du contact de connexion, et forme, par la distance entre la zone de contact et le contact de connexion, une première résistance (rn) de faible valeur ohmique, est connectée à la zone de contact, qui est reliée à une première ligne de liaison de faible valeur ohmique (fl) et à la seconde ligne de liaison (f2), et
- le seuil de commutation pour la mise à l'état conducteur, à la manière d'un thyristor, du transistor de dérivation (ta) et du transistor de substrat (ts) et la conductivité de la voie de courant de dérivation (sa) sont réglés à l'aide de la distance (s1) entre des première et seconde zones (z1, z2) et au moyen de la distance (z2) entre les première et seconde régions semiconductrice (H1, H2), de leur étendue en surface respective et de la longueur des zones marginales voisines.

6. Procédé selon la revendication 5, caractérisé par les caractéristiques suivantes :
- la mise à l'état conducteur, à la manière d'un thyristor, du transistor de dérivation (ta) comportant d'autres cuvettes pouvant être amorcées (W2) est empêchée par la valeur de la distance (s3) par rapport à ces autres cuvettes et par la dérivation des courants indésirables de substrat (i3, i4) au moyen de dispositifs de collecte (z5) situés dans la région intermédiaire définie par la distance (s3).

7. Procédé selon la revendication 6, caractérisé en ce que la dérivation des courants indésirables de substrat (i3 , i4) s'effectue au moyen d'une multiplicité de bornes de substrat, qui sont formées à partir d'une cinquième zone (z5) possédant le même type de conductivité que le substrat (Sb) et sont reliées à la première borne d'alimentation (VSS) et s'étendent à plat entre le transistor de dérivation (ta) et les autres cuvettes aptes à s'amorcer (W2).

8. Procédé selon la revendication 7, caractérisé en ce qu'au moyen de la troisième zone (z3) est formée une seconde résistance (rp), sur le contact de connexion opposé (a3) de laquelle est connectée une quatrième ligne de liaison (f4) pour des étages d'entrée associés (I).
